# EUROPEAN PATENT SPECIFICATION

(11) **EP 2 496 989 B1**
(45) Date of publication and mention of the grant of the patent: **02.10.2013**
(21) Application number: 10773564.9
(22) Date of filing: 02.11.2010
(51) Int. Cl.: G03F 7/00, G03F 9/00

(54) **Method and device for nanoimprint lithography**
Verfahren und Vorrichtung zur Nanoimprintlithografie
Méthode et dispositif pour la lithographie par nano-impression

(30) Priority: 02.11.2009 EP 09174779; 02.11.2009 US 257185 P
(43) Date of publication of application: 12.09.2012
(73) Proprietor: Danmarks Tekniske Universitet, 2800 Lyngby (DK); NIL Technology APS, 2800 Kgs. Lyngby (DK)
(72) Inventor: SMISTRUP, Kristian, DK-2100 Copenhagen Ø (DK); HEDEGAARD, Tobias, DK-2400 Copenhagen NV (DK); HANSEN, Ole, DK-2970 Hørsholm (DK)
(74) Representative: Plougmann & Vingtoft A/S
(86) International application number: PCT/DK2010/050294
(87) International publication number: WO 2011/050817

(56) References cited:
- EP-A2- 1 962 284
- WO-A2-2005/109095
- WO-A2-2007/067469
- US-A1- 2004 090 611
- US-A1- 2005 072 755
- US-A1- 2006 279 025
- US-A1- 2008 084 006
- US-A1- 2009 194 913
- ANONYMOUS: "Use of air pressure in an imprint method", RESEARCH DISCLOSURE, MASON PUBLICATIONS, HAMPSHIRE, GB, vol. 493, no. 74, 1 May 2005 (2005-05-01), XP007135109, ISSN: 0374-4353

## Description

### FIELD OF THE INVENTION

The invention relates to an apparatus and a method for imprinting of nano and micrometer structures, and particularly to such apparatus and method being based on a flexible stamp.

### BACKGROUND OF THE INVENTION

Nano imprint lithography (NIL) is a method for producing nano- and micrometer structures in imprintable materials by forcing a stamp with imprinting structures into an imprintable material. The imprinting structures are formed on a face of the stamp and the stamp itself may be rigid or flexible.

In cases where the stamp is flexible, the stamp deforms when it is pressed against the imprintable structure. Accordingly, it is a problem that the stamp may break if the deformations becomes to large. The stamp may be made more robust by making it less flexible, however at the cost of the capability of the flexible stamp to conform to non-flat imprinting surfaces. Thus, it is desirable to have a stamp which is flexible but also robust.

R. H. Pedersen, et al., 4 April, 2008, J. Micromech. Microeng. 18 (2008), pp. 1-9 discloses an apparatus for thermal nanoimprint lithography. The stamp is designed to significantly reduce the requirements for pressure application on the external imprint system. By MEMS-based processing, an air cavity inside the stamp is created, and the required pressure for successful imprint is reduced. Additionally, the stamp is capable of performing controlled demolding after imprint.

Whereas R. H. Pedersen, et al. discloses an alternative flexible stamp for nanoimprinting, the publication does not satisfactorily solve the problem of limiting the risk of breaking the stamp due to large deformations. Accordingly, an improved stamp is of benefit and, therefore, the following invention has been devised.

US 2008/0084006 discloses a contact lithography apparatus, system and method use a hydraulic deformation to facilitate pattern transfer. The apparatus, system and method include a spacer that provides a spaced apart proximal orientation of lithographic elements, and a hydraulic force member that provides the hydraulic deformation. One or more of the lithographic elements and the spacer is deformable, such that hydraulic deformation thereof facilitates the pattern transfer. The use of spacers implies deformation of one or more of the lithographic elements during the lithographic process which may be a problem.

WO 2007067469, US 2006279025 and US 2009194913 disclose impriting methods and devices with force providing means in one part of the device, and in a second part of the device an expandable cavity, whereby stamp and substrate are between the two parts.

### SUMMARY OF THE INVENTION

In general, the invention preferably seeks to alleviate or eliminate the above mentioned limitations with respect to fragile flexible stamps for nano and micrometer imprinting. In particular, an apparatus to be used with flexible stamps and which improves tolerance to breakage to the deformations of the stamp and a corresponding method is sought. It is appreciated that the invention may additionally or alternatively solve other problems, in particular other problems of the prior art.

To better address one or more of these concerns, in a first aspect of the invention a method for imprinting a micro/nano-meter pattern in or on a substrate is presented. The method comprises,
- providing a first part of an imprinting device comprising a force provider, where the force provider is an elastically deflectable member;
- providing a second part of the imprinting device, a stamp with micro/nano imprinting features and an expandable cavity defined at least by the stamp;
- providing a substrate adapted for being imprinted by the imprinting features, the substrate being placed between the force provider and the expandable cavity with the imprinting features of the stamp facing an imprintable surface of the substrate so as to force a part of the substrate to contact an adjacent part of the stamp;
- arranging the force provider, the expandable cavity and the substrate relative to each other so that the force provider is capable of pressing the substrate against the stamp so as to cause an initial deflection of the stamp relative to the un-deformed shape of the stamp in a direction away from the substrate before imprinting by subsequent expansion of the expandable cavity,- expanding the expandable cavity, so as to perform the imprinting of the imprinting features of the stamp in or on the substrate.

The micro/nano imprinting features may comprise protruding imprinting features and/or recessed imprinting features.

The force provider, the expandable cavity and the substrate may be arranged so that the substrate directly or indirectly contacts the stamp and so that the force provider directly or indirectly contacts the substrate. I.e. the substrate may be arranged between the force provider and the stamp.

Due to the elasticity of the force provider, the deformation of the stamp due to expansion of the expandable cavity is controlled by the contact force acting on the stamp and, thereby, by the elasticity of the force provider. Therefore, deformation of the stamp is controllable by the elasticity of force provider. Specifically, by providing a force provider having a stiffness which results in a first pressure from the force provider that is larger than a second pressure provided by the expandable cavity, even when the expandable cavity is most expanded, the substrate will not displace significantly.

In other words, due to the elasticity of the force provider, the substrate will always be hard-pressed against the stamp, such that the stamp is restricted from moving further than into the imprintable layer, provided that the pressures provided by the force provider is larger than the pressure provided by the expandable cavity.

As an example, the pressure provided by the force provider may be within the range from 1 to 5 bar, possibly up to 8 bar. The pressure provided by the expandable cavity may be with the range from 0.2 to 1 bar, for example 0.5 bar and possibly up to 6 bar. Clearly other pressures may be selected, for example in dependence of the imprintable material. However, generally the pressure given by the force provider should be larger than the force provided by the expandable cavity in order to avoid displacement of the substrate when the stamp is pressed against and into the substrate. The pressures may be generated by laboratory compressed air supplies capable of delivering pressured in the range from 6 to 10 bar. When soft polymer stamps are utilized imprinting may be performed with pressures of the expandable cavity as low as 0.05 bar. In comparison conventional imprinting tools may utilize pressures in the range from 10 to 50 bar.

The force provider may be made by elastic or viscoelastic materials or components such as springs, rubber, polymers, and foam materials. The position of the force provider relative to the stamp and the substrate may be adjustable to limit the required stroke length by the expandable cavity.

When the position of the force provider is adjustable, e.g. by adjusting screws or displacement actuators, uncoupled and individual control of the support pressure between the substrate or substrate back and the adjacent part of the stamp may be achieved, as well as uncoupled and individual control of the imprint pressure between the imprinting features and the substrate. In consequence, the deflection and deformation of the stamp may be controlled to avoid breakage of the stamp.

Furthermore, when the force provider is adjustable, the distance between the stamp and the force provider is variable so that substrates with different thicknesses may be used as well as stamps with different heights.

When the first and second parts are assembled a part of the substrate is forced to contact an adjacent part of the stamp since the force provider will be compressed and, thereby, provide a pressure against the substrate.

The pressure provided by the force provider may also press the stamp against a mounting surface of the second part so as to form an airtight or substantially airtight enclosure formed at least by the stamp, where the enclosure forms the expandable cavity.

Advantageously, different substrates with different thickness can be imprinted due to the elasticity of the force provider and the possible stroke amplitude of the stamp/expandable cavity.

It is understood that the part of the substrate which is able to be forced to contact an adjacent part of the stamp may comprise any suitable part of the substrate. Thus, the part may be the imprintable layer, the part may be a back support of the substrate upon which the imprintable layer is partially provided (i.e. no imprintable material is provided where contact is intended), or the part may be any other structure with a mounting face which is suited to establish a stable contact with a corresponding mounting face of the stamp.

It is understood that the expandability of the expandable cavity is determined at least in part by the elasticity of the stamp.

In a second aspect the invention relates to a method for imprinting a micro/nano-meter pattern in or on a substrate, the method comprising:
- providing a first part of an imprinting device comprising a force provider, where the force provider is an elastically deflectable member;
- providing a second part of the imprinting device,
   - a stamp-membrane,
   - an imprinting sheet comprising a side with micro/nano imprinting features (22) and a side configured to be laid on the stamp-membrane, and
   - an expandable cavity defined at least by the stamp-membrane,
- arranging the imprinting sheet on the stamp-membrane,
- providing a substrate adapted for being imprinted by the imprinting features of the imprinting sheet, the substrate being placed between the force provider and the expandable cavity with the imprinting features facing an imprintable surface of the substrate so as to force a part of the substrate to contact an adjacent part of the stamp-membrane,
- arranging the force provider, the expandable cavity and the substrate relative to each other so that the force provider is capable of pressing the substrate against the imprinting sheet so as to cause an initial deflection of the imprinting sheet relative to the un-deformed shape of the imprinting sheet in a direction away from the substrate before imprinting by subsequent expansion of the expandable cavity, and
- expanding the expandable cavity, so as to perform the imprinting of the imprinting features in or on the substrate.

The imprinting sheet may be arranged on the stamp-membrane by laying the imprinting sheet on the membrane so that the imprinting features faces the force provider.

By forcing a part of the substrate to contact an adjacent part of the stamp-membrane, e.g. a rest surface or a surface of an outer rim of the stamp-membrane, the substrate and the imprinting sheet may be stabilized relative to the stamp membrane.

Alternatively or additionally, a part of the substrate may be forced to contact an adjacent part of the imprinting sheet, when the imprinting sheet is extended to form a rest upon which the substrate can be forced against.

In the second aspect the stamp-membrane may be an elastic support for use with the imprinting sheet in a way where the imprinting sheet is arranged on the stamp-membrane before imprinting. This may be an advantage since the same stamp-membrane can be used with different imprinting sheets and since it may be less expensive to manufacture an imprinting sheet than a stamp.

In aspects related to the first and second aspects of the method for imprinting a micro/nano-meter pattern in or on a substrate, the step of "arranging the force provider, the expandable cavity and the substrate relative to each other so that the force provider is capable of pressing the substrate against the stamp (or imprinting sheet) so as to cause an initial deflection of the stamp (or imprinting sheet) relative to the un-deformed shape of the stamp (or imprinting sheet) in a direction away from the substrate before imprinting by subsequent expansion of the expandable cavity" may be dispensed with. For example, the stamp may not be initially deflected, instead the force provider may be arranged to press the substrate against the stamp so that the substrate is very close to the imprinting features or stamp or so that the substrate just touches the stamp. In another example the force provider and the expandable cavity are operated simultaneously so that the pressures provided by the force provider and the expandable cavity increases simultaneously, possibly at different rates, with the effect that the stamp is almost not deflected during imprinting.

In an embodiment the force provider may be a first expandable cavity and the expandable cavity may be a second expandable cavity, and the method may comprise,
- expanding the first expandable cavity, so as to force a part of the substrate or substrate back to contact an adjacent part of the stamp or stamp-membrane, and
- expanding the second expandable cavity, so as to perform the imprinting of the imprinting features in or on the substrate.

By replacing the force provider with a first expandable cavity so that first and second expandable cavities are available improved uncoupled and individual control of the support pressure and the imprint pressure may be achieved since the expansion of both cavities is controllable.

Thus, use of first and second expandable cavities may improve the capability of the imprinting device to reduce deformations of the stamp since both the pressure on the imprinting side of the stamp and the cavity side of the stamp is individually controllable. For example, the expansion of the first and second cavities may be adjusted gradually and alternately so that the maximum deformation of the stamp can be kept below an acceptable limit.

In an embodiment the second part may comprise a mounting surface arranged to form an airtight connection with a matching mounting surface of the stamp or the stamp-membrane so as to form the expandable cavity. Thus, the enclosure may advantageously be formed by the stamp or the stamp-membrane and a structural part of the second part to create the expandable cavity. A sufficient contact between the mounting surfaces may be established by the force provided by the force provider, additionally or alternatively adhesives may be used.

In an embodiment the stamp and the imprinting features are formed from a single piece of material. As an example, the stamp may advantageously be made from a silicon wafer and the imprinting features may be formed by etching in the top of the silicon wafer. Alternatively a feature layer (e.g. Silicon Oxide or polymer film) may be formed on top of the silicon wafer and the features may be defined by etching in the feature layer or by directly imprinting into the feature layer or by directly patterning the feature layer with a suitable patterning technique (e.g. electron beam lithography, laser writing or UV lithography).

In an embodiment the step of forcing the part of the substrate to contact the adjacent part of the stamp, may fixate and/or stabilise the substrate with respect to the stamp or the stamp-membrane. Accordingly, use of the force provider to fixate or stabilise the substrate relative to the stamp or stamp-membrane may be seen as a simple and efficient method for stabilising the substrate relative to the stamp or the stamp-membrane.

In relation to this embodiment, the stamp may comprise a rest for supporting the substrate to facilitate the contact between the substrate and the adjacent part of the stamp or the stamp-membrane. The rest may have a height slightly lower than the height of the imprinting features or substantially equal to the height of the imprinting features in a state where the stamp is un-deformed so that when the substrate is pressed against the rest of the stamp or the stamp-membrane then the base part of the stamp is slightly depressed.

In an embodiment the method for imprinting may further comprise the step of detaching the substrate from the stamp or imprinting sheet by contracting the expandable cavity. Since the stamp may form part of the expandable cavity, the stamp may advantageously be retracted from the substrate simply by contracting the expandable cavity. Depending on the adhesion or contact between the stamp-membrane and the imprinting sheet the imprinting sheet may be detached in the same manner.

A third aspect of the invention relates to an imprinting device for imprinting nano/micro features in or on an associated substrate by means of an associated stamp with micro/nano imprinting features, said device comprising:
- a first part comprising a force provider where the force provider is an elastically deflectable member,
- a second part comprising a mounting surface arranged to form a substantially airtight connection with a matching mounting surface of the stamp so as to form an expandable cavity; where
- the expandable cavity is configured, upon expansion, to perform the imprinting of the imprinting features of the stamp in or on the substrate, where
- the force provider is configured to force a part of the substrate to contact an adjacent part of the stamp, and where
- the force provider, the expandable cavity and the substrate are arrangeable relative to each other so that the force provider is capable of pressing the substrate against the stamp so as to cause an initial deflection of the stamp relative to the un-deformed shape of the stamp in a direction away from the substrate before imprinting by subsequent expansion of the expandable cavity

By arranging the substrate, the force provider and the expandable cavity so as to cause an initial deflection of the stamp relative to the un-deformed shape of the stamp in a direction away from the substrate before imprinting, the stamp is initially deformed but only by a small amount, e.g. by an amount defined by the protruding imprinting features or the height of the protrusions relative to a rest of the stamp upon which the substrate is supported. Due to the initial deflection it is advantageously achieved, that the stamp is minimally deformed during imprinting since the shape of the stamp is restored when the expandable cavity is expanded for imprinting.

The initial deflection of the stamp may be an initial bending of the stamp where the stamp is bended by contact with the substrate in a direction away from the substrate or equivalently away from the un-deformed shape of the stamp.

When the stamp comprises protruding imprinting features which protrudes beyond the support rest, at least part of the initial deflection is caused by contact between the substrate and the imprinting features. When the stamp only comprises recessed imprinting features, at least part of the initial deflection is caused by contact between the stamp and the bended substrate, where bending of the substrate is caused by contact with the force provider.

Thus, in addition to reducing the deformation of the stamp, the deformation of the substrate may also be reduced since the shape of both the stamp and the substrate may be at least partly restored during imprinting due to the subsequent expansion of the expandable cavity.

The arrangement or positioning of the substrate, the force provider and the expandable cavity may be performed so that the substrate is positioned between the force provider and the stamp so that the force provider is able to make contact with one side of the substrate and the other side of the substrate is able to make contact with the protruding features of the stamp, directly or indirectly via other layers.

Thus, the force provider may be seen as a device merely being configured to set a contact force between the stamp and the substrate which is sufficiently large to maintain the contact when the expandable cavity is expanded. Accordingly, a part of a first face (the non-imprintable face) of the substrate is arranged to face the force provider, and a part of a second face (the imprintable face) of the substrate is arranged to face the stamp.

In a fourth aspect the invention relates to an imprinting device for imprinting nano/micro features in or on an associated substrate by means of an associated imprinting sheet with micro/nano imprinting features, said device comprising:
- a first part comprising a force provider where the force provider is an elastically deflectable member,
- a second part comprising a mounting surface,
- a stamp-membrane comprising a mounting surface configured to form a substantially airtight connection with the matching mounting surface of the second part so as to form an expandable cavity, where the stamp-membrane has an outer side configured for making contact with a side of the imprinting sheet adjacent to the side with imprinting features, where
- the expandable cavity is configured, upon expansion, to perform the imprinting of the imprinting features of in or on the substrate, where
- the force provider is configured to force a part of the substrate to contact an adjacent part of the stamp-membrane, and where
- the force provider, the expandable cavity and the substrate are arrangeable relative to each other so that the force provider is capable of pressing the substrate against the imprinting sheet so as to cause an initial deflection of the imprinting sheet relative to the un-deformed shape of the imprinting sheet in a direction away from the substrate before imprinting by subsequent expansion of the expandable cavity.

The adjacent part of the stamp-membrane may be a surface of a rest or a rim structure, where the forcing of the substrate against the adjacent part may stabilize the substrate and the imprinting sheet relative to the stamp-membrane. The forcing of the substrate against the adjacent part may cause the initial deflection of the imprinting sheet.

Alternatively or additionally, the force provider is configured to force a part of the substrate to contact an adjacent part of the stamp-membrane or the imprinting sheet.

In the third and fourth aspects, the feature characterised so that "the force provider, the expandable cavity and the substrate are arrangeable relative to each other so that the force provider is capable of pressing the substrate against the imprinting sheet so as to cause an initial deflection of the imprinting sheet relative to the un-deformed shape of the imprinting sheet in a direction away from the substrate before imprinting by subsequent expansion of the expandable cavity" may be dispensed with similarly to the first and second aspects.

Advantages and effects described in relation the first and third aspects may also be found in relation the second and fourth aspects. For example, the advantageous reduction of the deformation of the stamp and substrate according to the first and third aspects are found as corresponding reductions of the deformation of the imprinting sheet and substrate according to the second and fourth aspects.

In an embodiment the force provider and the expandable cavity are arranged so as to reduce the deformation of the stamp or the imprinting sheet during imprinting relative to the deformation of the stamp or imprinting sheet when the stamp or imprinting sheet is initially deflected. The initial deflection of the stamp or imprinting sheet implies that the shape of the stamp or imprinting sheet is at least partly restored during imprinting so that deformations during imprinting are reduces. Thereby, more accurate imprinting may be achieved.

In an embodiment the stamp or stamp-membrane comprises a rest for supporting the substrate, where the rest has a height relative to the height of an upper surface of the stamp or imprinting sheet when they are un-deformed, so that the stamp or imprinting sheet is depressable by the pressure providable by the force provider before imprinting. The upper surface of the stamp or imprinting sheet may for example correspond to the height of protruding imprinting features or the height of surface of the stamp or imprinting sheet formed with recessed imprinting features. The height of the rest may correspond to the height of the base part of the stamp or imprinting sheet, i.e. the height of the bottom of imprinting features. Accordingly, as the substrate is laid on the rest or rim which encircles the stamp, the stamp will deflect due to the pressure on the substrate provided by the force provider and the indirect or direct contact between the stamp/imprinting sheet and the substrate.

Accordingly, the rest is configured to provide contact - directly or indirectly via some sheet or film layer - between the substrate and the stamp or imprinting sheet to cause an initial deflection of the stamp or imprinting sheet.

The force provider is an elastically deflectable member having an elasticity for generating a contact pressure against the stamp or imprinting sheet which is larger than the pressure against the stamp or imprinting sheet provided by the expandable cavity when the cavity is expanded for imprinting. The force provider may be made by elastic or viscoelastic materials or components such as springs, rubber, polymers, liquid, gel, and foam materials. Alternatively, the force provider may be formed by an elastic membrane, a cavity such as an expandable cavity having an expandable elastic membrane, a bellows, an elastic solid material. The force provider has an elasticity which is significantly smaller than the elasticity of solid materials such as metals including steel, aluminium or gold or other materials such a silicon or ceramics. Accordingly, whereas steel may have an elasticity in the order of 7000000 Newton/square centimetre or more, the force provider has an elasticity which is smaller a fraction of 1/100 or 1/1000 of the elasticity of steel, i.e. less than 7000 Newton/square centimetre.

By configuring the force provider with an elasticity for generating a contact pressure against the stamp or imprinting sheet which is larger than the pressure against the stamp or imprinting sheet provided by the expandable cavity when the cavity is expanded for imprinting, deformation of stamp or imprinting sheet during imprinting may be minimised since the substrate is fixated onto the rest of the stamp or stamp-membrane.

In an embodiment the force provider may be a first expandable cavity defined at least by a displaceable elastic means and the expandable cavity may be a second expandable cavity. The displaceable elastic means may be an elastic membrane, a rubber membrane, a rubber membrane comprising metal plates, a bellows, or other deformable material and structures.

In an embodiment, independent pressure controllers are arranged with the first and second expandable cavities so as to obtain independently expandable first and second cavities. The independent pressure controllers may be controllable or adjustable valves capable of reducing pressure or flow of the pressurizing fluid supplied by a common compressor to the first and second expandable cavities or the independent pressure controllers may be independent controllable compressors arranged for supplying pressurizing fluid to the first and second cavities. Advantageously, the independent pressure controllers allows the first and second cavities to be expanded independently so that e.g. firstly the first cavity is expanded to press the substrate against the rests of the stamp and secondly, the second cavity is expanded for imprinting. The independent pressure controllers may also ensure that the pressure provided by the first cavity is larger than the pressure provided by the second cavity.

In an embodiment the stamp or imprinting sheet may comprise an elastically bendable base part where the imprinting features are protruding or recessed features of the bendable base part.

In an embodiment the imprinting device may further comprise an integrated heating means or heater in the stamp or stamp-membrane. The integrated heating means may be a layer with resistive heating capabilities provided in or on the base part of the imprinting side of the stamp or stamp-membrane, or resistive wires provided on the stamp. It may be advantageous to enable heating of the substrate by integrated heating means since the low thermal heat capacity of the stamp and the substrate enables fast heating of the substrate with only a little amount of electric energy. The integrated heating means may advantageously enable an improved homogeneity of the substrate temperature due to the localised heating.

In an embodiment the second part may comprise two or more electric contactors (contact pads) arranged to establish electric contact with corresponding electric contactors arranged at a face of the stamp or stamp-membrane opposite to the imprinting face. Electric contactors may be understood as conductive structures formed to establish electric contact.

In an embodiment the imprinting device may further comprising a temperature sensor in the second part of the imprinting device. The temperature sensor may advantageously be integrated on a surface of the stamp or stamp-membrane and arranged to sense the temperature of the heating means and/or the substrate. It is contemplated that more than one temperature sensor may be provided. Thus, thousands of temperature sensors may be formed on the stamp. As an example, temperature sensors may be integrated in the stamp by creating resistors in the silicon part of the stamp. The resistance of such resistors will depend on temperature, and the resistance can thus be used as a measure of temperature.

In an embodiment the resistive heating means integrated in the stamp or stamp-membrane for heating may be used both for heating and for sensing the temperature. Since the resistance of the resistive heating means depends on the temperature, the temperature can be determined by monitoring the current running through the heater, either in dependence of the voltage over the heater or independent of the voltage if the current source has a substantially constant voltage output.

In an embodiment the first part may comprise a first heat insulation means and/or the second part may comprise a second heat insulation means for limitation of heat transfer from the stamp, stamp-membrane or imprinting sheet. Thus, the first part, the second part or both parts part may be provided with heat insulation means in order to reduce heat conduction. The heat insulation means may be a slab or layer of insulating material such as PEEK material, foam materials, glass, or other suited materials.

In an embodiment the imprinting device may comprise first and second fluid channels for guiding a fluid into the respective first and/or second expandable cavities. The fluid channels may be formed as drilled holes though the top and bottom of the first and second parts. The fluid channels may enable expansion of the respective cavities, and additionally the fluid channels of the second part may enable cooling of the stamp and substrate by pumping a fluid through the second cavity.

In an embodiment the stamp or imprinting sheet may comprise first and second imprinting sections being integrated with a base part, wherein the first and the second imprinting sections are mechanically weakly coupled in a direction substantially parallel to an imprinting direction of the stamp.

In an embodiment the effective bending stiffness of the first and the second imprinting sections may be substantially larger than the effective bending stiffness of the base part in a direction substantially parallel to an imprinting direction of the stamp or imprinting sheet. This ratio of bending stiffness may advantageously improved imprinting of uneven surfaces.

A fifth aspect of the invention relates to a system for imprint lithography comprising the imprinting device according to the second aspect and further comprising:
- a control unit; and
- an input/output means adapted for connecting the control unit with the device; wherein the control unit is adapted for controlling the imprinting device via the input/output means according to computer-generated control commands and/or measures of one or more physical properties retrieved from the imprinting device.

In an embodiment the control unit may be configured for controlling heating of the integrated heating means during imprinting.

It is appreciated that the imprinting device may be used for various nano/micro imprinting techniques, for example UV imprinting. Accordingly, UV light generating emitters, e.g. UV light emitting devices, may be integrated in the second expandable cavity so that UV light can be transmitted through the UV transparent stamp to cure the imprinted substrate. For example, UV light emitting devices may be arranged to emit light into the stamp or stamp-membrane from the side of the stamp or membrane, e.g. below the surface of the rest for supporting the substrate. This may provide an efficient way of transmitting UV light into the substrate since light is guided by the base part of the stamp and scattered into the substrate via imprinting features and other surface parts of the membrane.

Applications of the inventions comprises manufacturing of light emitting diodes, integrated optics (including photonic band gap structures), lenses, optical devices, surface energy engineering, surface bio compatibility engineering, improved cooling and heat transfer, automotive means, active and passive optical elements, displays, storage (including hard disc and optical storages), RAM, MEMS, NEMS, antireflection surfaces, solar cells, PV elements, batteries, bio filters, water filters, quantum devices, surface enhanced Raman spectroscopy, anti-reflection, colour, friction, anti-fog improvements of cars and planes, controlled air/liquid friction of windmill wings, air craft wings, car bodies, ship bodies, and manufacturing of watch faces.

In summary the invention relates to an imprinting device for imprinting nano/micro structures. The imprinting device comprises a second expandable cavity constituted in part by a membrane of the stamp. The membrane is flexible and formed in such a way so that when fluid is pumped into the expandable cavity then the membrane expands towards the imprintable substrate and imprints the substrate. The imprinting device is further provided with a force provider, alternatively a first expandable cavity, for forcing a contact part of the substrate to make contact with a matching contact part of the stamp. The elasticity of the force provider or the strength of the first expandable cavity, i.e. the ability of the first expandable cavity to press the substrate against the stamp, reduces or eliminates the risk for damaging the stamp since the second expandable cavity has an expansion strength or elasticity sufficiently small compared to the force provider so that the membrane of the stamp is not deformed beyond the elastic limits of the membrane.

In general the various aspects of the invention may be combined and coupled in any way possible within the scope of the invention. These and other aspects, features and/or advantages of the invention will be apparent from and elucidated with reference to the embodiments described hereinafter.

### BRIEF DESCRIPTION OF THE DRAWINGS

Embodiments of the invention will be described, by way of example only, with reference to the drawings, in which
Fig. 1 shows an imprinting device with an inserted stamp and imprintable substrate,
Fig. 2 shows an example of a stamp,
Fig. 3 shows an example of electrical connectors provided on the imprinting device for establishing electrical connections with the stamp,
Fig. 4 shows an alternative imprinting device provided with insulation layers and a heater layer on the stamp,
Fig. 5 shows different designs of stamps,
Figs. 6-9 show first, second, third and fourth imprinting steps according to the imprinting process,
Fig. 10 shows a controller for controlling the imprinting process,
Fig. 11 shows initial bending of the substrate and the stamp, and
Fig. 12 shows a stamp which comprises a removable imprinting sheet laid onto a stamp-membrane.

### DESCRIPTION OF EMBODIMENTS

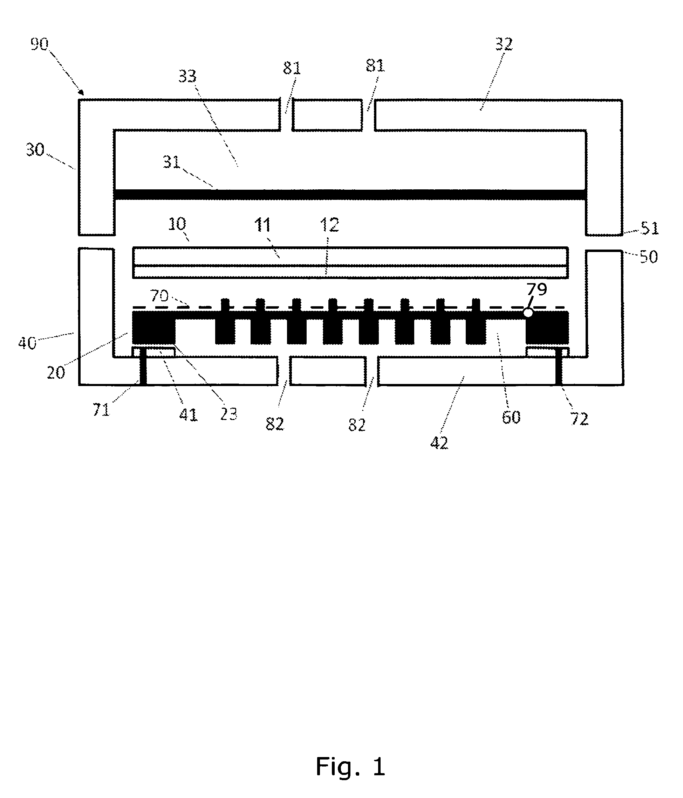

Fig. 1 illustrates an imprinting device 90 for imprinting nano or micro features in or on an associated substrate 10 by means of an associated stamp 20. Said substrate may comprise an imprintable material 12, such as an imprint resist 12, provided on a back 11, such as a silicon, glass or metal plate.

In the context of the present invention, it is to be understood that imprinting nano or micro meter features may relate to imprinting features having dimensions being less than 100 micrometers, preferably less than 50 micrometers, or more preferably less than 25 micrometers.

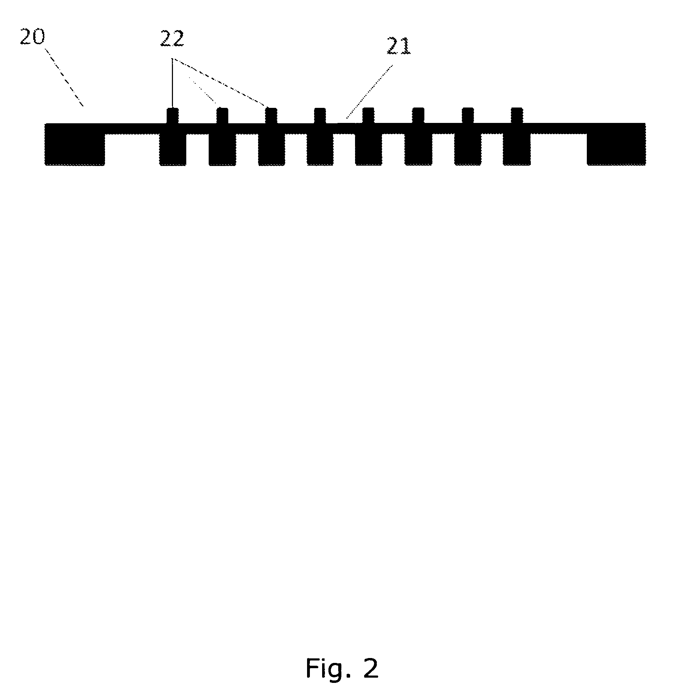

In an embodiment shown in Fig. 2, the above-mentioned stamp may comprise an elastically bendable base part 21, possibly having a flexible membrane-like structure and imprinting features 22 protruding from the base part 21. The stamp 20 may be monolithically formed from a single piece of material. For example, the stamp may be produced from a silicon wafer and the imprinting features 22 may made by oxidation of parts of the silicon wafer so that the imprinting features consists of silicon dioxide. The stamp may also be made from a light transparent material, e.g. UV light transparent glass, for enabling UV imprinting. In another embodiment the stamp is made from two or more different materials. For example, the base part 21 may be made from an elastic material such as metal, glass or silicon, and the imprinting features 22 may be made from a different material, for example a sheet of polycarbonate having imprinting features 22 formed therein. In case of a two-component stamp 20, the separate piece of material with imprinting features may be joined to the base part 21, e.g. by gluing.

The imprinting device 90 shown in Fig. 1 comprises a first part 30 comprising a force provider 33 and a first frame 32. The force provider 33 may be formed by an elastic membrane 31, a cavity, a bellows, an elastic solid material, a foam material or springs.

In an embodiment, the force provider 33 is a first expandable cavity defined at least by a displaceable elastic means 31, e.g. an elastic rubber membrane. Thus, the elastic means 31 and the frame 32 forms an enclosure which forms the first expandable cavity 33. Alternatively, the expandable cavity 33 may be formed by a bellows which may have an elastic or soft end portion for averaging pressures against the substrate.

Moreover, said imprinting device 90 comprises a second part 40 comprising a mounting surface 41 arranged to form a substantially airtight connection with a matching mounting surface 23 of the stamp 20 so as to form an expandable cavity 60. The expandable cavity 60 may be a second expandable cavity 60 which is formed by an enclosure defined at least by the stamp 20 or as shown in Fig. 1, the enclosure is defined by the stamp 20 and the second frame 42. When the stamp 20 is comprised by an elastically deformable membrane or base part 21, the cavity 60 is expandable due to this elasticity.

The first expandable cavity or enclosure 33 and the second expandable cavity or enclosure 60 may be forced to expand by various means. Thus, in one embodiment the expandable cavities may be forced to expand by supplying a fluid into the cavities, for example ambient air, a gas, or a liquid. Alternatively, expansion may be achieved by heating the cavities so that the enclosed fluid expands. As an example, a liquid or solid contained in the cavities may be heated to evaporate so as to cause expansion of the cavity.

In an embodiment, the imprinting device further comprises first and second fluid channels 81, 82 for guiding a fluid into the respective first and second expandable cavities. Although two fluid channels 81 are shown for each of the first and second expandable cavities 33, 60, a single fluid channel for each cavity may be sufficient. Use of two or more fluid channels for each cavity may be beneficial for improved control of the fluid pressure and, thereby, expansion. Uses of two or more fluid channels may also enable flushing of the cavities by use one of the channels as an inlet and another channel as an outlet. Flushing of the second expandable cavity may be used to cool the substrate, by flushing a fluid through the cavity.

The fluid or different fluids used to expand the first and second cavities 81, 82 may result in fluid pressures which are different or substantially different for each one of the cavities 33, 60.

The first and second parts 30, 40 of the imprinting device may be provided with fastening means, e.g. bolts and threaded holes for connecting the interfaces 50, 51 of the first and second parts 30, 40. Alternatively, when glass, e.g. borofloat or borosilicate glass, is used for forming one of interfaces 50, 51 (or one of the first and second parts 30, 40) and silicon is used for forming the other interface 50, 51 (or the other part 30, 40) the connection may be achieved by use of anodic bonding by contacting the interfaces and heating the interface made of glass while cooling the side made of silicon.

In a preferred embodiment, the imprinting device further comprises an integrated heating means 70 in the second part of the imprinting device. The heating means 70 may be integrated with the stamp 20 illustrated in Fig. 1 as a dotted line 70.

The integrated heating means 70 is capable of raising the temperature of the imprintable substrate 10 without unnecessary heating of other parts. Thereby, less energy is required, and the temperature can be raised faster with great homogeneity. In this way a homogeneous elevated temperature in the upper part of the stamp and, thereby, the imprintable substrate 10, can be obtained prior to and during the imprint process. The heating means may be realized by creating a pattern with high concentration of phosphorous ions in or on the surface of the imprinting side of the stamp 20. This will form a conductor in the surface of the stamp.

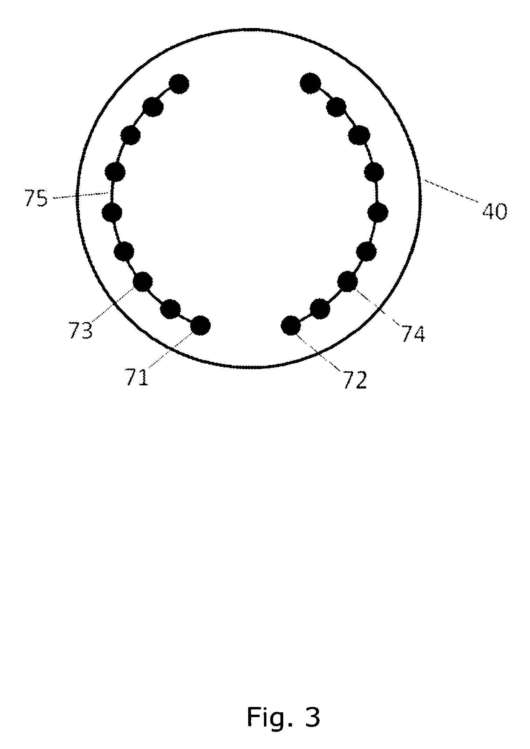

Current may be supplied to the heating means 70 via pair of conductors 71, 72 which are electrically connectable with the stamp 20. In order to improve uniformity of the heat generated by the heating means 70, a plurality of distributed conductors 71-74 may be provided as shown in Fig. 3 which shows the second part 40 in a viewing direction towards the mounting face 41. A first group of conductors 71, 73 electrically connected via a low resistive conductor 75 and a second group of electrically connected conductors 72, 74 are provided so that the first group are electrically connected to the second group via the heating means 70. Since current is divided among the conductors of the first group and second group as well, the flow of current through the heating means 70 is made more uniform over the area of the heating means. Consequently, a more uniform heating may be achieved.

The conductors 71-74 may be formed as electrically conductive lead pins passing through the bottom part of the second frame 42, which may be formed by a single material or a sandwich construction. The conductive lead pins 71-74 may terminate at the mounting face 41 of the second part 40. The terminations of the lead pins may be formed as contactors or contact pads, i.e. metal plates having a contact area being larger than the cross-sectional area of the lead pins. The corresponding mounting face 23 of the stamp 20 may be provided with corresponding contactors (not shown) to establish electrical connections from the second part 40, via the mounting faces 23, 41 to the stamp. It may be advantageous to arrange the contactors of the stamp 20 at a face 23 opposite to the imprinting face, since this enables the substrate 10 and the imprinting side of the stamp 20 to have the same foot-print. That is, if the contactors or other electrical connections means were provided on the imprinting side of the stamp 20, the stamp would need to have a larger foot-print than the substrate 10.

Accordingly, the imprinting device may further comprise contact pads in the second part of the imprinting device to enable electric connection between the conductors 71, 72 and the heating means 70. Thus, the contact pads enable electric connection to the heating element 70 via the back side of the stamp 20, e.g. through the mounting surface 23. Since the heating means 70 is integrated with the stamp 20 and since the heating means 70 is electrically contacted from the back side of the stamp, the stamp is beneficially allowed to have the same foot print as the imprintable substrate 10.

It is appreciated that conductors other the conductors 71-74 may be arranged similarly to the conductors 71-71, but electrically insulated from these conductors, to provide electrical connections for other purposes such at connections for temperature sensing, position actuators, etc.

In a preferred embodiment, the imprinting device further comprises a temperature sensor 79 in the second part of the imprinting device which enables accurate temperature control during imprinting of the substrate 10 with respect to a desired temperature reference. In an embodiment, the temperature of the heating means 70 may be controlled during the imprinting period without feedback from a temperature sensor by supplying a current via the conductors 71, 72, where the current may be constant or varied according to a fixed schedule.

The volume formed between the force provider 33 of the first part 30 and the expandable cavity 60 of the second part is used for hosting the imprintable substrate.

It is appreciated that the imprinting device 90 may be sold without the imprintable substrate 10 and the stamp 20, but the imprinting device is configured to be operated with a stamp 20, e.g. in terms of matching mounting surfaces 41, to enable forming the expandable cavity 60. Generally, various types of substrates 10 may be used with the imprinting device.

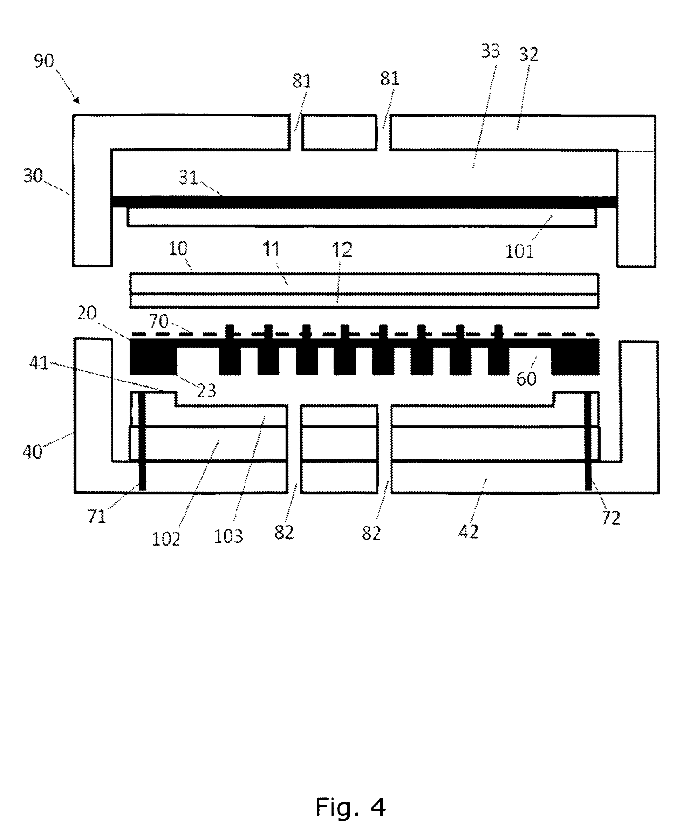

Fig. 4 shows an embodiment where the first part 30 comprises a first heat insulation means 101 and, additionally or alternatively the second part 40 comprises a second heat insulation means 102 for limitation of heat transfer from the stamp 20, the heating means 70 and the substrate 10. The insulations means 101,102 may be formed from slabs of heat insulating material such as PEEK. Due to the relative low heating capacity of the integrated heating means 70, insulation by insulation means 101,102 may be advantageous to ensure fast heating of the stamp 20 and the imprintable substrate 10. Since the insulation means 102 may be relatively soft, a layer of harder material 103, e.g. borofloat glass, may advantageously be located on top of the insulation layer 102 to ensure an airtight or substantially airtight connection to the stamp 20. Thus, the hard layer material may be provided with a mounting surface 41 to form a substantially airtight connection to the mounting surface 23 of the stamp 20.

In an embodiment the insulation means 101 may be formed as sandwich construction comprising layers of insulation material and metal plates to achieve a more rigid insulation layer 101.

It is appreciated that the sandwich construction of first and second parts 30, 40 may be designed in various different ways to achieve specify advantages. According to another specific design the second part is designed as a sandwich construction comprising the following layers (from bottom and upwards):
- An aluminum chuck or plate at the bottom, and
- An insulating plate (e.g. made from PEEK) provided with electrical contactors or connection means.

The stamp is located directly on top of the insulating plate of the second part and the substrate 10 with imprint resist or other imprintable layer is located on top of the stamp, with the imprintable layer facing the imprinting features.

The sandwich construction of the first part comprises the following layers (from bottom and upwards):
- A Teflon sheet, e.g. having a thickness of 0.1 mm, arranged to face the non-imprintable face of the substrate 10,
- A double side polished silicon wafer, e.g. having a thickness of 0.35 mm,
- Another Teflon sheet,
- An insulating plate, e.g. made from PEEK,
- The force provider 33, and
- A top aluminum chuck or plate.

The use of Teflon provides additional mechanical flexibility and resilience and the silicon wafer provides additional heat conduction and heat distribution. Furthermore, the silicon wafer may average local pressure differences caused by the force provider 33.

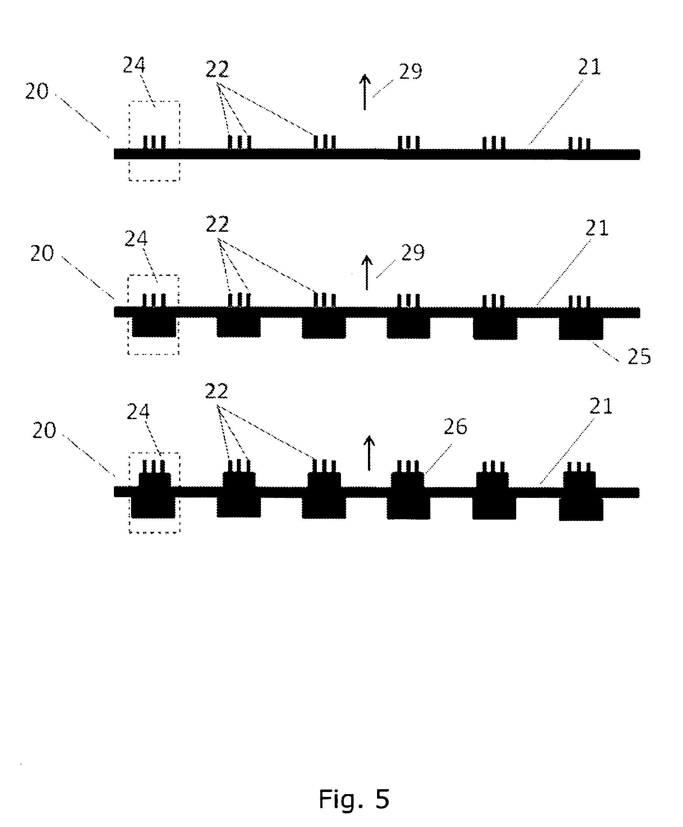

Fig. 5 shows three different types of stamps. All three stamps 20 comprise imprinting features 22 and a membrane-like base part 21. The imprinting features may be grouped in imprinting sections 24.

In the upper stamp all imprinting features 22 are connected via the base part 21 so that the stamp has the same or substantially the same bending stiffness over the entire area of the stamp.

In the middle stamp, first and second imprinting sections 24 each comprises imprinting features 22 formed on the imprinting side of the base part 21 and thickenings 25 formed on the back side of the base part 21 adjacent to a group of imprinting features contained within each imprinting section 24. At the locations where the thickening 25 are formed, the bending stiffness is larger compared to adjacent locations, i.e. locations where the membrane 21 is relatively thin.

The lower example of a stamp 20 distinguishes from the middle stamp by having imprinting features 22 formed on additional thickenings 26, so-called mesa structures, formed on the imprinting side of the base part 21.

Common to all stamps in Fig. 5 is that the stamps comprise first and second imprinting sections 24 being integrated with a base part 21, wherein the first and the second imprinting sections are mechanically weakly coupled in a direction substantially parallel to an imprinting direction 29 of the stamp.

Common to the stamps provided with thickenings 25, 26 is that the effective bending stiffness of the first and the second imprinting sections 24 is substantially larger than the effective bending stiffness of the base part 21 in a direction substantially parallel to an imprinting direction 29 of the stamp.

It may be seen as an advantage that the entire base part 21 of the stamp is flexible or that the bending stiffness of thickened parts of the stamp is larger than the bending stiffness of sections of the base part interconnecting the thickened parts, since this design enables the stamp to conform to a non-planar surface of the substrate by use of only small imprinting forces. Furthermore, variations in the height of the imprinting features 22 between imprinting sections 24 are possible due to the loosely coupled imprinting sections.

Typical values of the thickness of the base part 21 ranges from 50-150 µm. However, other thicknesses are equally applicable.

Whereas the stamps shown in Fig. 5 may be advantageously in connection with the imprinting device inhere, this does not exclude that other different types of stamps may be used.

Details of the design of stamps as disclosed in Fig. 5, such as manufacturing methods and dimensions of the base part, the imprinting features and the thickenings and mesa structures are discloses in PCT/DK2005/000570 which is hereby incorporated by reference.

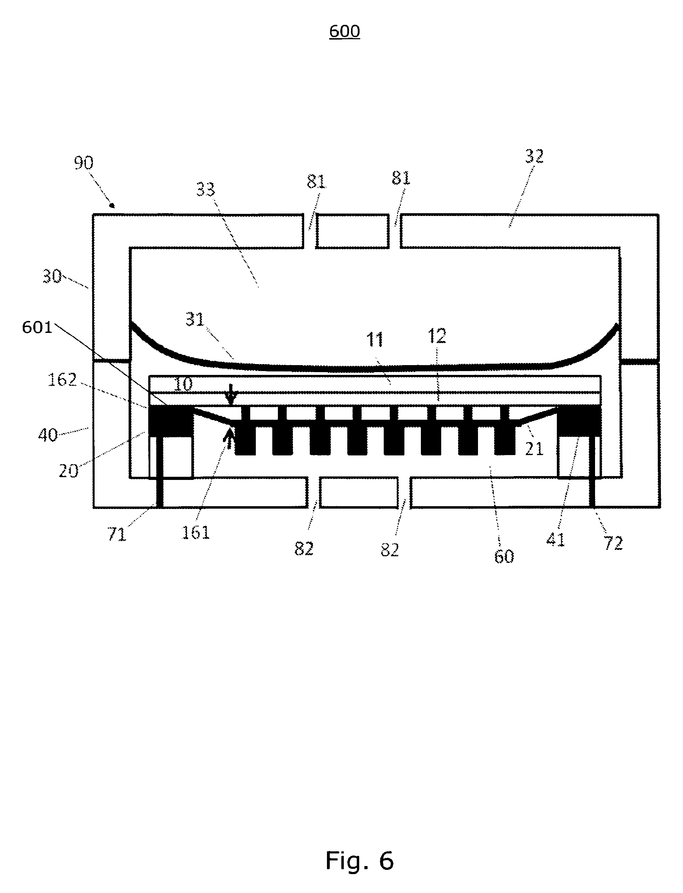

Figs. 6-9 illustrate steps in a process for imprinting a micro nano-meter structure 10 in or on a substrate using the imprinting device 90. Whereas the steps of the process are presented in a preferred order, different orders may be used. Additionally, some of the described steps may be omitted and other intermediate steps may be included.

Fig. 6 illustrates a first step 600 where the first expandable cavity 33 in the form of a fluid cavity is expanded by pumping a fluid into the cavity via one or more of the inlets or fluid channels 81. The increased pressure within the cavity causes the displaceable elastic means, e.g. a membrane 31, to expand and press the substrate 10 to contact an adjacent part 162 of the stamp 20. The substrate 10 may contact the adjacent part 162 of the stamp so that a part of the imprintable surface 12 contacts a plane contact surface of the stamp 20. Alternatively, the substrate back 11 may be arranged, e.g. by removing the imprintable layer 12 from parts of the substrate 10, to contact an adjacent part of the stamp. Thus, said adjacent part of the stamp serves as a rest 601 to which the substrate 10 can be laid against. The surface of the rest 601 may be in approximately the same level as the base part or membrane 21 so that the top points of the protruding imprinting features 22 protrudes beyond the surfaces of the rest. Alternatively, the surface of the rest 601 may be in approximately the same level as the top surfaces of the protruding imprinting features 22. The examples for the relative height of the rests 601 are only examples and the level of the rests 601 may be selected differently under the constraint that it should be possible to contact the substrate with the stamp without generating large deformations of the stamp and preferably so that the deformation of the stamp during imprinting is minimised relative to an initial deflection. The contact between the imprinting features of the stamp 20 and the substrate 10 causes the membrane 21 of the stamp to deflect by an amplitude 161. The deflection amplitude 161 is within the elastic deformation limits of the stamp 20.

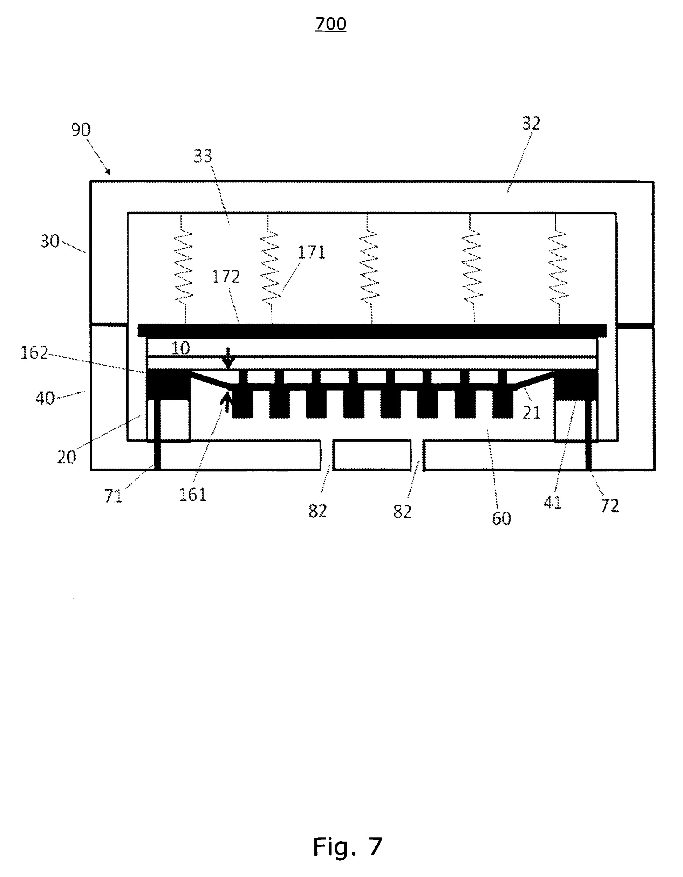

Fig. 7 shows an alternative first step 700 in case where the force provider 33, here in form of springs 171 and a forcing plate 172 is used to force the substrate 10 to contact an adjacent part 162 of the stamp 20. Thus, in Fig. 7 the springs 161 may be compressed only by an amount being sufficient to deflect the membrane 21 by an amount 161 to establish contact between substrate 10 and stamp 20 or they may be compressed more to ensure a stronger contact between the substrate 10 and the stamp 20 to withstand the pressure from the second expandable cavity. The position of the force providing means 33 relative to the second part 40 may be adjustable to ensure correct depression of the springs 171 and, thereby, the correct contact force between the substrate and the stamp.

Thus, it is contemplated that the force provider 33 serves to establish a proper pressure against the substrate 10 so as establish a contact force between the substrate 10 and the stamp 20 being sufficient to maintain contact between the substrate 10 and the stamp 20, also when the second cavity 60 is expanded. The force provider 33 may be an expandable cavity 33 or an elastic construction, e.g. the spring-plate construction in Fig. 7.

Equivalently, the force provider 33 may be seen as a first cavity 33 comprising passive or active force providing means and generators that may provide a force on the substrate 10. Such force providing means or generators may include springs, resilient means (rubber or polymers), actuators (electrical, pneumatic, hydraulic), etc.

It is understood that initially and before carrying out the steps according to Fig. 6 and Fig. 7, the stamp 20 has been mounted on the mounting surface 41 of the second part 40. Additionally, the substrate has been provided, e.g. by laying the substrate 10 on top of the stamp 20. Finally, the first and second parts 30, 40 are assembled.

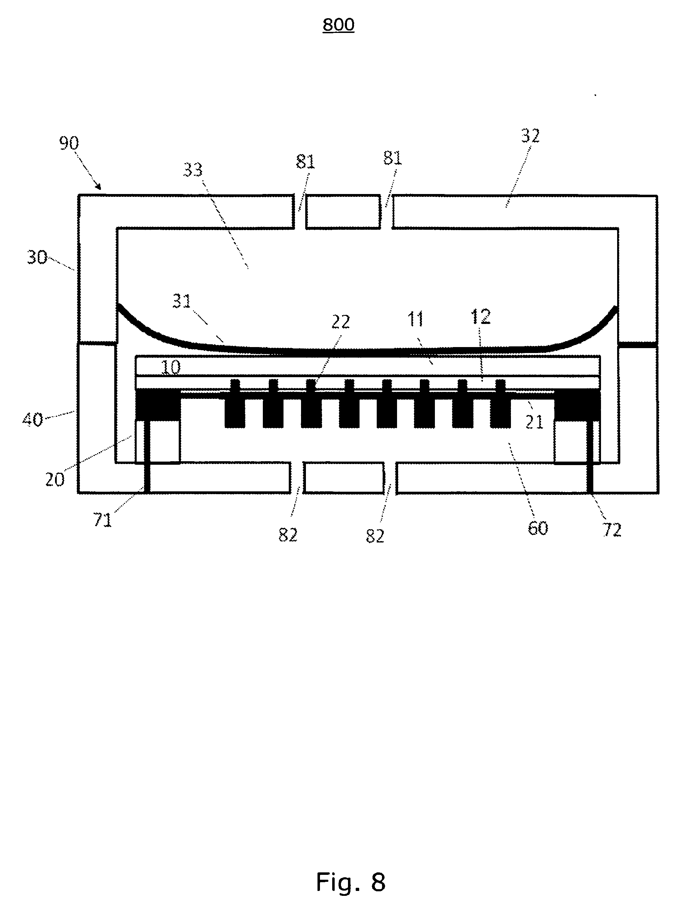

Fig. 8 illustrates a subsequent step 800 where the second expandable cavity 60 is expanded to cause a pressure on the membrane 21 large enough to press the imprinting features 22 into the substrate 10, i.e. an imprintable layer 12. The expansion is achieved by pumping a fluid via one or more of the inlets 82 into the cavity formed by the stamp 20 and the mounting surface 41 of the second part 40. Thus, expansion of the second cavity 60 causes imprinting of the imprinting features in or on the substrate 10.

Before and preferably during the period of imprinting of the imprinting features 22, a heater 70 may be heated by injecting an electric current via conductors 71, 72. The heat generated by the heater 70, warms up the upper surface layer of the substrate 10, so that the viscosity of the imprintable resist or polymer 12 changes. The change of viscosity enables the imprinting features 22 to penetrate into the imprintable layer 12 so enable the imprinting. The heater 70 is not illustrated in Fig. 8 for convenience, but reference is made to Fig. 1 and Fig. 4.

Typical temperature values of the heater 70 is within the range from 50°C - 250°C, preferably within 80°C - 190°C, more preferred within 100°C - 170°C. These values are relevant for the following imprinting materials 12: PMMA, Topas (COC), mr-I 7030. Thus, heating temperatures may be widely chosen depending e.g. on the imprinting material 12.

Whereas heating of the substrate 10 may be performed by use of the integrated heater 70, alternatively or additionally the entire imprinting device 90 may be heated by an external heater. It is also appreciated that heating of the substrate 10 may not be required for some imprintable materials.

It is important to control the deflection of the membrane 21 during expansion of the second cavity 60 in order to prevent stamp breakage of the stamp. If the membrane 21 is allowed to deflect towards the first part 30 beyond given threshold the membrane 21 may crack. By ensuring the pressure provided by the force provider 33 is larger pressure provided by the second expandable cavity 60, the stamp 20 will not be able to lift the substrate, and hence the membrane deflection is limited, at least to the imprint resist thickness. It is noted that the initial deflection 161 of the membrane 21 is less than the critical limit of a few microns and less than the potential deflection amplitude of the membrane 21 in a direction towards the first part 30 in case that the position of the substrate 10 was not controlled by the force provider 33.

The expansion of the second cavity 60 may be performed in a single step or may be performed gradually over time to control and limit the stress effects on the stamp 20.

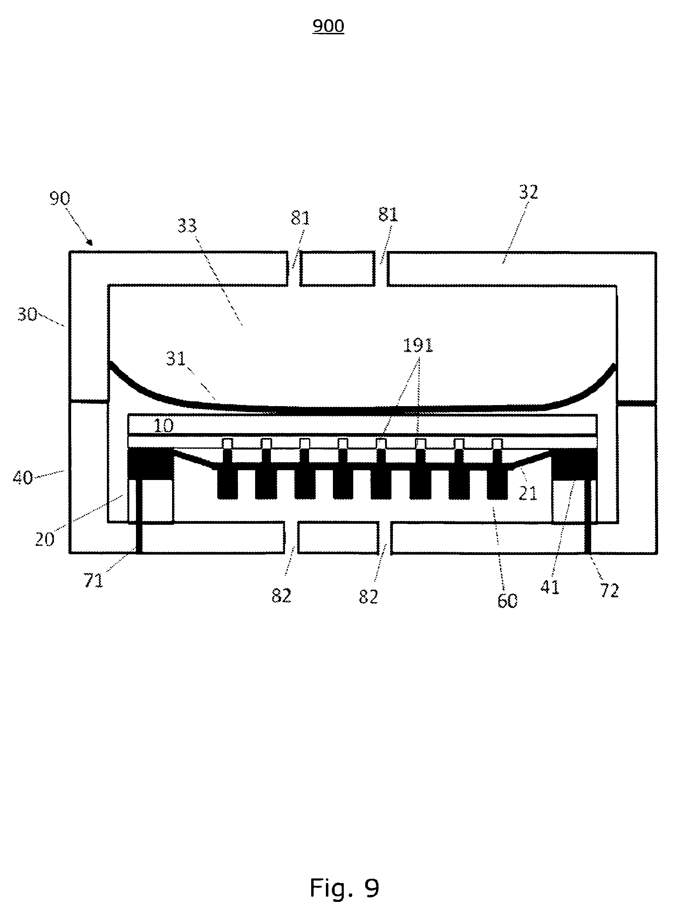

Fig. 9 shows an optional subsequent step 900 where the pressure within the second expandable cavity 60 is reduced by pumping fluid out of the cavity 60 via the fluid channels 82, e.g. to cause a vacuum inside the cavity, so that the membrane 21 of the stamp 20 is forced away from the substrate 10. The retraction of the imprinting features 22 from the substrate leaves the imprinted structure 191 in the substrate 10.

Before, the stamp 20 is retracted from the substrate 10 the substrate may be required to cool down. It is appreciated that the second expandable cavity 60 may be used for active cooling after imprint. Thus, by flushing a cold fluid through the second cavity 60 by pumping the fluid into the cavity via one of the fluid channels 82 and out of the cavity via another fluid channel 82, the cooling process of the substrate 10 may be speeded up so that a higher imprinting yield may be achieved.

As an example the thickness of the substrate may be within the range from 0.1 mm to 2 mm. A silicon wafer used for the substrate back 11 may have a thickness of 500-525 µm, whereas glass plates used the substrate back 11 may have a thickness of 0,5-1 mm. Other thicknesses are possible.

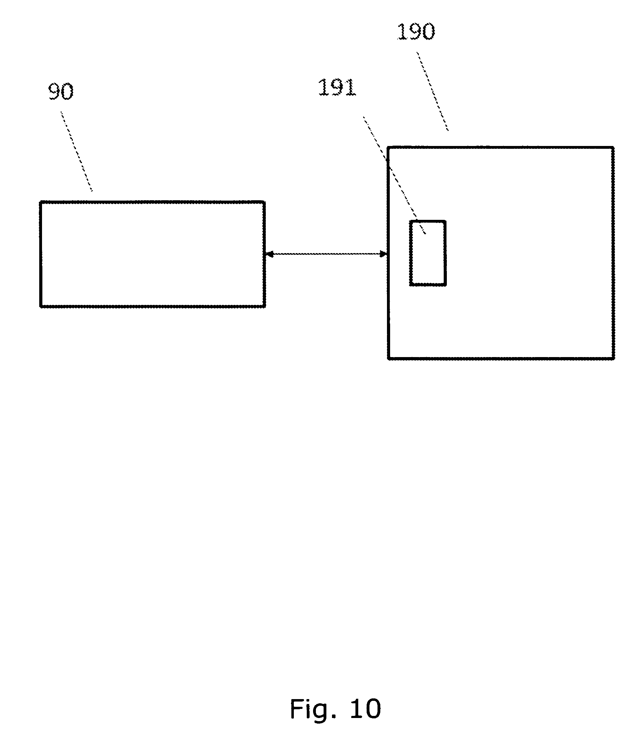

Fig. 10 shows a system 100 imprint lithography comprising the imprinting device 90 and a control unit 190 having input/output means 191, such a electrical input/output connectors for connecting the control unit with the imprinting device 90. The control 190 unit is adapted for controlling the imprinting device via the input/output means 191 according to possible computer-generated control commands and/or measures of one or more physical properties retrieved from the imprinting device, such as temperature properties. Accordingly, a computer, possibly integrated with the control unit 190, may be provided to control the imprinting process via controllers for controlling the heating means 70 and controllers for receiving temperature measurements.

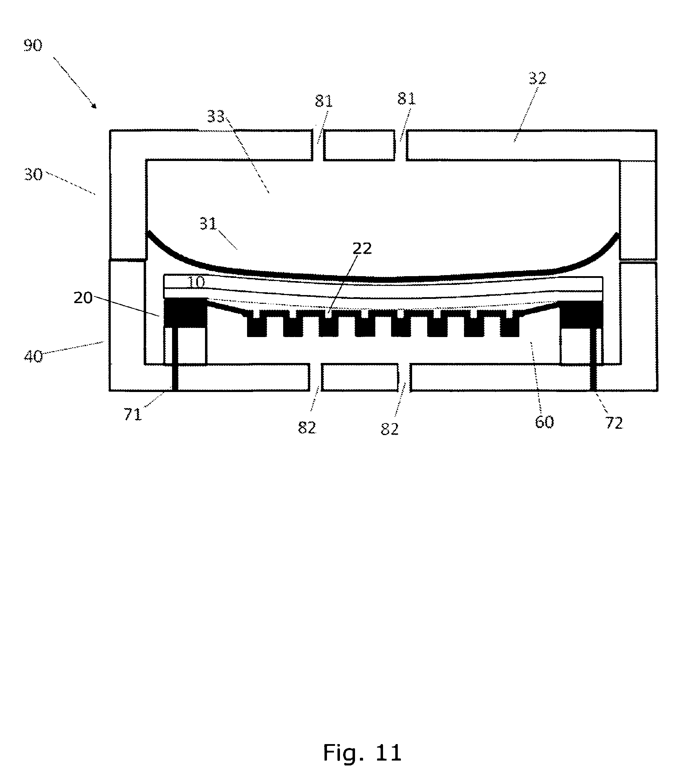

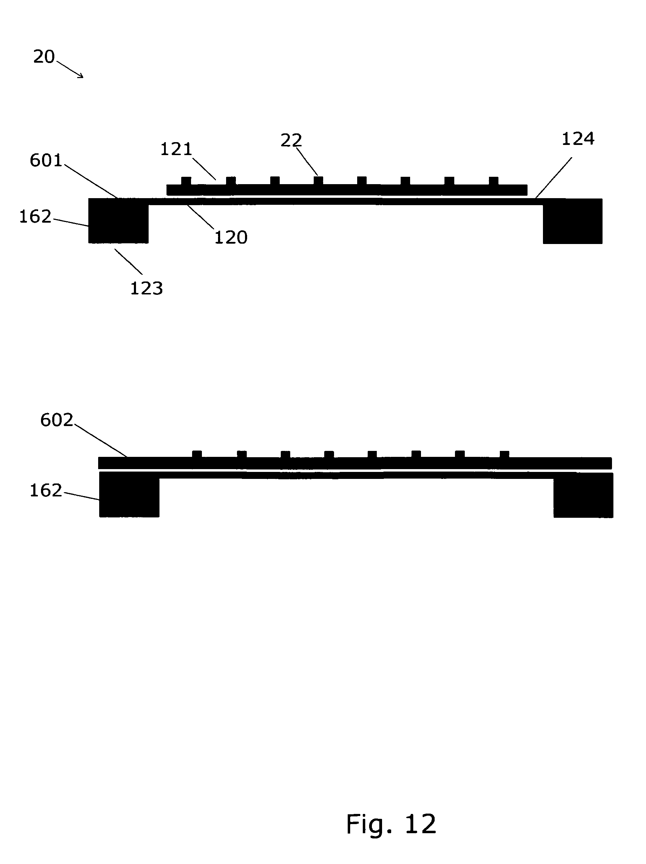

Fig. 11 provides an example where the imprinting features 22 are not formed as protruding imprinting features as shown in the preceding figures, but at recessed imprinting features. Fig. 11 illustrates that the stamp is initially deflected relative to its un-deformed shape in a direction away from the substrate 10. The deflection is cause by the pressure provided by the bendable substrate 10. Accordingly, in a subsequent imprinting step, the cavity formed in part by the stamp is expanded to cause imprinting of the depressed imprinting features 22 into or onto the imprintable layer of the substrate 10. In the expanded state of the stamp, the deformation of the stamp and imprinting features is negligible or at least smaller than in deflected state so that an improved imprinting quality is achieved. Fig. 12, upper view, shows an alternative embodiment where the stamp 20 is constituted by an imprinting sheet 121 and a stamp-membrane or stamp part 120.

The imprinting sheet 121 has imprinting features 22 equivalent with the imprinting features of the stamp 20. The imprinting sheet is formed as a sheet of elastic material which may be of the same type as the material of the stamp. Further, the imprinting features of the imprinting sheet may be produced using the same procedures as described for the stamp, e.g. by oxidation. The imprinting sheet has two sides, one side that comprises the imprinting features and an adjacent side which is configured to be laid onto and make contact with an outer side 124 of the stamp-membrane. The imprinting sheet may be fixated to the stamp-membrane by use of adhesives or the imprinting sheet may be placed onto the stamp-membrane without use of adhesives or other fixation means.

The stamp-membrane 120 comprises an outer side 124 for holding the imprinting sheet. The stamp-membrane 120 also comprises a rest 601 formed as a surface of part 162. The rest 601 of the stamp-membrane and the function of the rest is equivalent to the rest 601 of the stamp 20. The stamp-membrane 120 further comprises a mounting surface 123 arranged to form an airtight connection with a matching surface 41 of the second part 40.

When the imprinting sheet is in contact with the stamp-membrane, the functionality and characteristics of the assembly of the stamp-membrane 120 and the imprinting sheet 121 is equivalent with the stamp. For example, the imprinting sheet may be initially depressed by pressure provided by the force provider via the substrate 10 to achieve a reduced deformation of the imprinting sheet or imprinting features during the subsequent expansion of the expandable cavity.

Fig. 12, lower view, shows an embodiment where the imprinting sheet is extended so that it covers the part 162 of the stamp-membrane and so that a surface or rim of the imprinting sheet has the function of a rest 602 for contacting the substrate and stabilising the substrate.

While the invention has been illustrated and described in detail in the drawings and foregoing description, such illustration and description are to be considered illustrative or exemplary and not restrictive; the invention is not limited to the disclosed embodiments. Other variations to the disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. Any reference signs in the claims should not be construed as limiting the scope.

## Claims

1. A method for imprinting a micro/nano-meter pattern in or on a substrate, the method comprising:
- providing a first part (30) of an imprinting device (90) comprising a force provider (33), where the force provider is an elastically deflectable member,
- providing a second part (40) of the imprinting device, a stamp (20) with micro/nano imprinting features (22) and an expandable cavity (60) defined at least by the stamp,
- providing a substrate (10) adapted for being imprinted by the imprinting features, the substrate being placed between the force provider and the expandable cavity with the imprinting features of the stamp facing an imprintable surface (12) of the substrate so as to force a part of the substrate to contact an adjacent part of the stamp,
- arranging the force provider, the expandable cavity and the substrate relative to each other so that the force provider is capable of pressing the substrate against the stamp so as to cause an initial deflection of the stamp relative to the un-deformed shape of the stamp in a direction away from the substrate before imprinting by subsequent expansion of the expandable cavity,
- expanding the expandable cavity, so as to perform the imprinting of the imprinting features of the stamp in or on the substrate.

2. A method for imprinting a micro/nano-meter pattern in or on a substrate, the method comprising:
- providing a first part (30) of an imprinting device (90) comprising a force provider, where the force provider is an elastically deflectable member (33);
- providing a second part (40) of the imprinting device,
- a stamp-membrane (120),
- an imprinting sheet (121) comprising a side with micro/nano imprinting features (22) and a side configured to be laid on the stamp-membrane, and
- an expandable cavity (60) defined at least by the stamp-membrane,
- arranging the imprinting sheet on the stamp-membrane,
- providing a substrate (10) adapted for being imprinted by the imprinting features of the imprinting sheet, the substrate being placed between the force provider and the expandable cavity with the imprinting features facing an imprintable surface (12) of the substrate so as to force a part of the substrate to contact an adjacent part of the stamp-membrane,
- arranging the force provider, the expandable cavity and the substrate relative to each other so that the force provider is capable of pressing the substrate against the imprinting sheet so as to cause an initial deflection of the imprinting sheet relative to the un-deformed shape of the imprinting sheet in a direction away from the substrate before imprinting by subsequent expansion of the expandable cavity,
- expanding the expandable cavity, so as to perform the imprinting of the imprinting features in or on the substrate.

3. A method for imprinting according to claim 1 or 2, where the force provider is a first expandable cavity and the expandable cavity is a second expandable cavity, and where the method comprises,
- expanding the first expandable cavity (33), so as to force a part of the substrate to contact an adjacent part of the stamp or the stamp-membrane, and
- expanding the second expandable cavity (60), so as to perform the imprinting of the imprinting features in or on the substrate.

4. A method for imprinting according to claim 1, 2 or 3, where the step of forcing the part of the substrate or the substrate back to contact the adjacent part of the stamp or the stamp-membrane fixates and/or stabilises the substrate with respect to the stamp or stamp-membrane.

5. A method for imprinting according to claim 1 or 2, further comprising the step of detaching the substrate from the stamp or imprinting sheet by contracting the expandable cavity.

6. An imprinting device for imprinting nano/micro features in or on an associated substrate by means of an associated stamp (20) with micro/nano imprinting features (22), said device comprising:
- a first part (30) comprising a force provider (33), where the force provider is an elastically deflectable member,
- a second part (40) comprising a mounting surface (41) arranged to form a substantially airtight connection with a matching mounting surface (23) of the stamp so as to form an expandable cavity (60); where
- the expandable cavity is configured, upon expansion, to perform the imprinting of the imprinting features of the stamp in or on the substrate, where
- the force provider is configured to force a part of the substrate to contact an adjacent part of the stamp, and where
- the force provider, the expandable cavity and the substrate are arrangeable relative to each other so that the force provider is capable of pressing the substrate against the stamp so as to cause an initial deflection of the stamp relative to the un-deformed shape of the stamp in a direction away from the substrate before imprinting by subsequent expansion of the expandable cavity.

7. An imprinting device for imprinting nano/micro features in or on an associated substrate by means of an associated imprinting sheet (121) with micro/nano imprinting features (22), said device comprising:
- a first part (30) comprising a force provider (33), where the force provider is an elastically deflectable member,
- a second part (40) comprising a mounting surface (41),
- a stamp-membrane (120) comprising a mounting surface (123) configured to form a substantially airtight connection with the matching mounting surface (41) of the second part (40) so as to form an expandable cavity (60), where the stamp-membrane has an outer side (124) configured for making contact with a side of the imprinting sheet adjacent to the side with imprinting features, where
- the expandable cavity is configured, upon expansion, to perform the imprinting of the imprinting features in or on the substrate, where
- the force provider is configured to force a part of the substrate to contact an adjacent part of the stamp-membrane, and where
- the force provider, the expandable cavity and the substrate are arrangeable relative to each other so that the force provider is capable of pressing the substrate against the imprinting sheet so as to cause an initial deflection of the imprinting sheet relative to the un-deformed shape of the imprinting sheet in a direction away from the substrate before imprinting by subsequent expansion of the expandable cavity.

8. An imprinting device according to claim 6 or 7, where the force provider and the expandable cavity are arranged so as to reduce the deformation of the stamp or imprinting sheet during imprinting relative to the deformation when the stamp or imprinting sheet is initially deflected.

9. An imprinting device according to claim 6 or 7, where the force provider is a first expandable cavity defined at least by a displaceable elastic means (31) and the expandable cavity is a second expandable cavity.

10. An imprinting device according to claim 9, where independent pressure controllers are arranged with the first and second expandable cavities so as to obtain independently expandable first and second cavities.

11. An imprinting device according to claim 6 or 7, further comprising an integrated heating means (70) in the stamp or stamp-membrane.

12. An imprinting device according to claim 6 or 7, where the second part comprises two or more electric contactors arranged to establish electric contact with corresponding electric contactors arranged at a face of the stamp or stamp-membrane.

13. An imprinting device according to any of the preceding claims, further comprising a temperature sensor (12) in the second part of the imprinting device.

14. An imprinting device according to claim 6 or 7, where the first part comprises a first heat insulation means (101) and/or the second part comprises a second heat insulation means (102) for limitation of heat transfer from the stamp or stamp-membrane.

15. A system for imprint lithography comprising the imprinting device according to claim 6 or 7 and further comprising:
- a control unit (190); and
- an input/output means (191) adapted for connecting the control unit with the imprinting device (90);
wherein the control unit is adapted for controlling the imprinting device via the input/output means according to computer computer-generated control commands and/or measures of one or more physical properties retrieved from the imprinting device.

## Patentansprüche

1. Verfahren zum Drucken eines Mikro-/Nanomusters in oder auf einem Substrat, wobei das Verfahren umfasst:
- Bereitstellen eines ersten Teils (30) einer Druckvorrichtung (90), umfassend einen Kraftausüber (33), wobei der Kraftausüber ein elastisch ablenkbares Element ist,
- Bereitstellen eines zweiten Teils (40) der Druckvorrichtung, eines Druckstempels (20) mit Mikro-/Nanodruckmerkmalen (22) und eines expandierbaren Hohlraums (60), der mindestens von dem Stempel festgelegt wird,
- Bereitstellen eines Substrats (10), beschaffen für das Bedrucken mit den Druckmerkmalen, wobei das Substrat zwischen dem Kraftausüber und dem expandierbaren Hohlraum angeordnet ist, wobei die Druckmerkmale des Stempels gegenüber einer bedruckbaren Fläche (12) des Substrats liegen, sodass ein Teil des Substrats mit einem benachbarten Teil des Stempels in Kontakt gedrückt wird,
- Anordnen des Kraftausübers, des expandierbaren Hohlraums und des Substrats in Bezug zueinander, sodass der Kraftausüber in der Lage ist, das Substrat gegen den Stempel zu drücken, um so vor dem Drucken durch eine anschließende Ausdehnung des expandierbaren Hohlraums eine erste Ablenkung des Stempels in Bezug auf die nicht verformte Form des Stempels in eine Richtung weg vom Substrat zu verursachen,
- Ausdehnen des expandierbaren Hohlraums, sodass das Drucken der Druckmerkmale des Stempels in oder auf dem Substrat durchgeführt wird.

2. Verfahren zum Drucken eines Mikro-/Nanomusters in oder auf einem Substrat, wobei das Verfahren umfasst:
- Bereitstellen eines ersten Teils (30) einer Druckvorrichtung (90), umfassend einen Kraftausüber, wobei der Kraftausüber ein elastisch ablenkbares Element (33) ist,
- Bereitstellen eines zweiten Teils (40) der Druckvorrichtung,
- einer Stempelmembran (120),
- eines Druckbogens (121), umfassend eine Seite mit Mikro-/Nanodruckmerkmalen (22) und eine Seite, die dazu konfiguriert ist, auf die Stempelmembran gelegt zu werden, und
- eines expandierbaren Hohlraums (60), der mindestens durch die Stempelmembran festgelegt wird,
- Anordnen des Druckbogens auf der Stempelmembran,
- Bereitstellen eines Substrats (10), beschaffen für das Bedrucken mit den Druckmerkmalen des Druckbogens, wobei das Substrat zwischen dem Kraftausüber und dem expandierbaren Hohlraum angeordnet ist, wobei die Druckmerkmale gegenüber einer bedruckbaren Fläche (12) des Substrats liegen, sodass ein Teil des Substrats mit einem benachbarten Teil der Stempelmembran in Kontakt gedrückt wird,
- Anordnen des Kraftausübers, des expandierbaren Hohlraums und des Substrats in Bezug zueinander, sodass der Kraftausüber in der Lage ist, das Substrat gegen den Druckbogen zu drücken, um so vor dem Drucken durch eine anschließende Ausdehnung des expandierbaren Hohlraums eine erste Ablenkung des Druckbogens in Bezug auf die nicht verformte Form des Druckbogens in eine Richtung weg vom Substrat zu verursachen,
- Ausdehnen des expandierbaren Hohlraums, sodass das Drucken der Druckmerkmale in oder auf dem Substrat durchgeführt wird.

3. Druckverfahren nach Anspruch 1 oder 2, wobei der Kraftausüber ein erster expandierbarer Hohlraum ist und der expandierbare Hohlraum ein zweiter expandierbarer Hohlraum ist und wobei das Verfahren umfasst
- Ausdehnen des ersten expandierbaren Hohlraums (33), sodass ein Teil des Substrats in Kontakt mit einem benachbarten Teil des Stempels oder der Stempelmembran gedrückt wird, und
- Ausdehnen des zweiten expandierbaren Hohlraums (60), sodass das Drucken der Druckmerkmale in oder auf dem Substrat durchgeführt wird.

4. Druckverfahren nach Anspruch 1, 2 oder 3, wobei der Schritt des Drückens des Teils des Substrats oder des Substrats zurück in Kontakt mit dem benachbarten Teil des Stempels oder der Stempelmembran das Substrat in Bezug auf den Stempel oder die Stempelmembran fixiert und/oder stabilisiert.

5. Druckverfahren nach Anspruch 1 oder 2, weiterhin umfassend den Schritt des Ablösens des Substrats von dem Stempel oder dem Druckbogen durch Zusammenziehen des expandierbaren Hohlraums.

6. Druckvorrichtung zum Drucken von Nano-/Mikromerkmalen in oder auf einem verbundenen Substrat mithilfe eines verbundenen Stempels (20) mit Mikro-/Nanodruckmerkmalen (22), wobei die Vorrichtung umfasst:
- ein erstes Teil (30), umfassend einen Kraftausüber (33), wobei der Kraftausüber ein elastisch ablenkbares Element ist,
- ein zweites Teil (40), umfassend eine Auflagefläche (41), die zur Ausbildung einer im Wesentlichen luftdichten Verbindung mit einer entsprechenden Auflagefläche (23) des Stempels beschaffen ist, um einen expandierbaren Hohlraum (60) auszubilden; wobei
- der expandierbare Hohlraum konfiguriert ist, nach dem Ausdehnen das Drucken der Druckmerkmale des Stempels in oder auf dem Substrat durchzuführen.
- der Kraftausüber konfiguriert ist, einen Teil des Substrats in Kontakt mt einem benachbarten Teil des Stempels zu drücken, und wobei
- der Kraftausüber, der expandierbare Hohlraum und das Substrat in Bezug zueinander angeordnet werden können, sodass der Kraftausüber in der Lage ist, das Substrat gegen den Stempel zu drücken, um so vor dem Drucken durch eine anschließende Ausdehnung des expandierbaren Hohlraums eine erste Ablenkung des Stempels in Bezug auf die nicht verformte Form des Stempels in eine Richtung weg vom Substrat zu verursachen.

7. Druckvorrichtung zum Drucken von Nano-/Mikromerkmalen in oder auf einem verbundenen Substrat mithilfe eines verbundenen Druckbogens (121) mit Mikro-/Nanodruckmerkmalen (22), wobei die Vorrichtung umfasst:
- ein erstes Teil (30), umfassend einen Kraftausüber (33), wobei der Kraftausüber ein elastisch ablenkbares Element ist,
- ein zweites Teil (40), umfassend eine Auflagefläche (41),
- eine Stempelmembran (120) umfassend eine Auflagefläche (123), die zur Ausbildung einer im Wesentlichen luftdichten Verbindung mit einer entsprechenden Auflagefläche (41) des zweiten Teils (40) beschaffen ist, um einen expandierbaren Hohlraum (60) auszubilden, wobei die Stempelmembran eine Außenseite (124) aufweist, die dazu konfiguriert ist, Kontakt mit einer Seite des Druckbogens neben der Seite mit Druckmerkmalen herzustellen, wobei
- der expandierbare Hohlraum konfiguriert ist, nach dem Ausdehnen das Drucken der Druckmerkmale in oder auf dem Substrat durchzuführen, wobei
- der Kraftausüber konfiguriert ist, einen Teil des Substrats in Kontakt mt einem benachbarten Teil der Stempelmembran zu drücken, und wobei
- der Kraftausüber, der expandierbare Hohlraum und das Substrat in Bezug zueinander angeordnet werden können, sodass der Kraftausüber in der Lage ist, das Substrat gegen den Druckbogen zu drücken, um so vor dem Drucken durch eine anschließende Ausdehnung des expandierbaren Hohlraums eine erste Ablenkung des Druckbogens in Bezug auf die nicht verformte Form des Druckbogens in eine Richtung weg vom Substrat zu verursachen.

8. Druckvorrichtung nach Anspruch 6 oder 7, wobei der Kraftausüber und der expandierbare Hohlraum so angeordnet sind, dass die Verformung des Stempels oder des Druckbogens während des Druckens im Vergleich zur Verformung bei der ersten Ablenkung des Stempels oder des Druckbogens gemindert wird.

9. Druckvorrichtung nach Anspruch 6 oder 7, wobei der Kraftausüber ein erster expandierbarer von mindestens einem verschiebbaren elastischen Element (31) festgelegter Hohlraum ist und der expandierbare Hohlraum ein zweiter expandierbarer Hohlraum ist.

10. Druckvorrichtung nach Anspruch 9, wobei unabhängige Drucksteuerungen in Verbindung mit dem ersten und zweiten Hohlraum angeordnet sind, um einen unabhängigen expandierbaren ersten und zweiten Hohlraum zu erreichen.

11. Druckvorrichtung nach Anspruch 6 oder 7, weiterhin umfassend ein eingebautes Heizmittel (70) in dem Stempel oder der Stempelmembran.

12. Druckvorrichtung nach Anspruch 6 oder 7, wobei das zweite Teil zwei oder mehr elektrische Schütze umfasst, die zum Schaffen eines elektrischen Kontakts mit entsprechenden an einer Fläche des Stempels oder der Stempelmembran angeordneten elektrischen Schützen angeordnet sind.

13. Druckvorrichtung nach einem der vorhergehenden Ansprüche, weiterhin umfassend einen Temperatursensor (12) im zweiten Teil der Druckvorrichtung.

14. Druckvorrichtung nach Anspruch 6 oder 7, wobei das erste Teil ein erstes Wärmedämmmittel (101) und/oder das zweite Teil ein zweites Wärmedämmmittel (102) zur Begrenzung der Wärmeübertragung von dem Stempel oder der Stempelmembran umfasst.

15. System für den Litografiedruck, umfassend die Druckvorrichtung nach Anspruch 6 oder 7 und weiterhin umfassend:
- eine Steuereinheit (190); und
- ein Eingabe-/Ausgabemittel (191), beschaffen zum Verbinden der Steuereinheit mit der Druckvorrichtung (90);
wobei die Steuereinheit zum Steuern der Druckvorrichtung über das Eingabe-/Ausgabemittel gemäß computergenerierten Steuerbefehlen und/oder Messungen von einem oder mehreren von der Druckvorrichtung erhaltenen physikalischen Eigenschaften beschaffen ist.

## Revendications

1. Méthode d'impression d'un motif micro/nanométrique dans ou sur un substrat, la méthode comprenant :
- l'apport d'une première partie (30) d'un dispositif d'impression (90) comprenant un applicateur de force (33), où l'applicateur de force est un élément pouvant subir une flexion élastique,
- l'apport d'une deuxième partie (40) du dispositif d'impression, d'une matrice (20) possédant des micro-/nano-structures d'impression (22) et d'une cavité expansible (60) définie au moins par la matrice,
- l'apport d'un substrat (10) adapté pour recevoir l'empreinte des structures d'impression, le substrat étant placé entre l'applicateur de force et la cavité expansible alors que les structures d'impression de la matrice se trouvent face à une surface imprimable (12) du substrat de manière à forcer une partie du substrat à entrer en contact avec une partie adjacente de la matrice,
- la disposition de l'applicateur de force, de la cavité expansible et du substrat les uns par rapport aux autres de manière à ce que l'applicateur de force soit capable de presser le substrat contre la matrice afin de provoquer une flexion initiale de la matrice par rapport à la forme non déformée de la matrice, dans une direction s'éloignant du substrat, avant l'impression par expansion ultérieure de la cavité expansible,
- l'expansion de la cavité expansible, de manière à exécuter l'impression des structures d'impression de la matrice dans ou sur le substrat.

2. Méthode d'impression d'un motif micro/nanométrique dans ou sur un substrat, la méthode comprenant :
- l'apport d'une première partie (30) d'un dispositif d'impression (90) comprenant un applicateur de force, où l'applicateur de force est un élément pouvant subir une flexion élastique (33),
- l'apport d'une deuxième partie (40) du dispositif d'impression,
- d'une matrice-membrane (120),
- d'une plaque d'impression (121) comprenant une face possédant des micro-/nano-structures d'impression (22) et une face configurée pour être placée sur la matrice-membrane, et
- d'une cavité expansible (60) définie au moins par la matrice-membrane,
- la disposition de la plaque d'impression sur la matrice-membrane,
- l'apport d'un substrat (10) adapté pour recevoir l'empreinte des structures d'impression de la plaque d'impression, le substrat étant placé entre l'applicateur de force et la cavité expansible alors que les structures d'impression se trouvent face à une surface imprimable (12) du substrat de manière à forcer une partie du substrat à entrer en contact avec une partie adjacente de la matrice-membrane,
- la disposition de l'applicateur de force, de la cavité expansible et du substrat les uns par rapport aux autres de manière à ce que l'applicateur de force soit capable de presser le substrat contre la plaque d'impression afin de provoquer une flexion initiale de la plaque d'impression par rapport à la forme non déformée de la plaque d'impression, dans une direction s'éloignant du substrat, avant l'impression par expansion ultérieure de la cavité expansible,
- l'expansion de la cavité expansible, de manière à exécuter l'impression des structures d'impression dans ou sur le substrat.

3. Méthode d'impression selon la revendication 1 ou 2, où l'applicateur de force est une première cavité expansible et la cavité expansible est une deuxième cavité expansible, et où la méthode comprend :
- l'expansion de la première cavité expansible (33), de manière à forcer une partie du substrat à entrer en contact avec une partie adjacente de la matrice ou de la matrice-membrane, et
- l'expansion de la deuxième cavité expansible (60), de manière à exécuter l'impression des structures d'impression dans ou sur le substrat.

4. Méthode d'impression selon la revendication 1, 2 ou 3, où l'étape consistant à forcer la partie du substrat ou le dos du substrat à entrer en contact avec la partie adjacente de la matrice ou de la matrice-membrane fixe et/ou stabilise le substrat par rapport à la matrice ou à la matrice-membrane.

5. Méthode d'impression selon la revendication 1 ou 2, comprenant en outre l'étape consistant à séparer le substrat de la matrice ou de la plaque d'impression par contraction de la cavité expansible.

6. Dispositif d'impression pour l'impression de nano/micro-structures dans ou sur un substrat associé au moyen d'une matrice (20) associée possédant des micro/nano-structures d'impression (22), ledit dispositif comprenant :
- une première partie (30) comprenant un applicateur de force (33), où l'applicateur de force est un élément pouvant subir une flexion élastique,
- une deuxième partie (40) comprenant une surface de montage (41) disposée pour former un raccord essentiellement hermétique avec une surface de montage correspondante (23) de la matrice de manière à former une cavité expansible (60) ; où
- la cavité expansible est configurée, lors de l'expansion, pour exécuter l'impression des structures d'impression de la matrice dans ou sur le substrat, où
- l'applicateur de force est configuré pour forcer une partie du substrat à entrer en contact avec une partie adjacente de la matrice, et où
- l'applicateur de force, la cavité expansible et le substrat peuvent être disposés les uns par rapport aux autres de manière à ce que l'applicateur de force soit capable de presser le substrat contre la matrice afin de provoquer une flexion initiale de la matrice par rapport à la forme non déformée de la matrice, dans une direction s'éloignant du substrat, avant l'impression par expansion ultérieure de la cavité expansible.

7. Dispositif d'impression pour l'impression de nano/micro-structures dans ou sur un substrat associé au moyen d'une plaque d'impression (121) associée possédant des micro-/nano-structures d'impression (22), ledit dispositif comprenant :
- une première partie (30) comprenant un applicateur de force (33), où l'applicateur de force est un élément pouvant subir une flexion élastique,
- une deuxième partie (40) comprenant une surface de montage (41),
- une matrice-membrane (120) comprenant une surface de montage (123) configurée pour former un raccord essentiellement hermétique avec la surface de montage correspondante (41) de la deuxième partie (40) de manière à former une cavité expansible (60), où la matrice-membrane possède une face externe (124) configurée pour entrer en contact avec une face de la plaque d'impression adjacente à la face possédant des structures d'impression, où
- la cavité expansible est configurée, lors de l'expansion, pour exécuter l'impression des structures d'impression dans ou sur le substrat, où
- l'applicateur de force est configuré pour forcer une partie du substrat à entrer en contact avec une partie adjacente de la matrice-membrane, et où
- l'applicateur de force, la cavité expansible et le substrat peuvent être disposés les uns par rapport aux autres de manière à ce que l'applicateur de force soit capable de presser le substrat contre la plaque d'impression afin de provoquer une flexion initiale de la plaque d'impression par rapport à la forme non déformée de la plaque d'impression, dans une direction s'éloignant du substrat, avant l'impression par expansion ultérieure de la cavité expansible.

8. Dispositif d'impression selon la revendication 6 ou 7, où l'applicateur de force et la cavité expansible sont disposés de manière à réduire la déformation de la matrice ou de la plaque d'impression pendant l'impression par rapport à la déformation obtenue quand la matrice ou la plaque impression subit la flexion initiale.

9. Dispositif d'impression selon la revendication 6 ou 7, où l'applicateur de force est une première cavité expansible définie au moins par un moyen élastique déplaçable (31) et la cavité expansible est une deuxième cavité expansible.

10. Dispositif d'impression selon la revendication 9, où des régulateurs de pression indépendants sont associés à la première et à la deuxième cavité expansible de manière à obtenir une première et une deuxième cavité qui sont expansibles indépendamment.

11. Dispositif d'impression selon la revendication 6 ou 7, comprenant en outre un moyen de chauffage (70) intégré à la matrice ou à la matrice-membrane.

12. Dispositif d'impression selon la revendication 6 ou 7, où la deuxième partie comprend au moins deux contacteurs électriques disposés pour établir un contact électrique avec des contacteurs électriques correspondants disposés sur une face de la matrice ou de la matrice-membrane.

13. Dispositif d'impression selon l'une quelconque des revendications précédentes, comprenant en outre une sonde de température (12) dans la deuxième partie du dispositif d'impression.

14. Dispositif d'impression selon la revendication 6 ou 7, où la première partie comprend un premier moyen d'isolation thermique (101) et/ou la deuxième partie comprend un deuxième moyen d'isolation thermique (102) pour limiter le transfert de chaleur depuis la matrice ou la matrice-membrane.

15. Système de lithographie par impression comprenant le dispositif d'impression selon la revendication 6 ou 7 et comprenant en outre :
- une unité de contrôle (190) ; et
- un moyen d'entrée/sortie (191) adapté pour raccorder l'unité de contrôle au dispositif d'impression (90) ;
où l'unité de contrôle est adaptée pour contrôler le dispositif d'impression par l'intermédiaire du moyen d'entrée/sortie en fonction de commandes de contrôle générées par ordinateur et/ou de mesures d'une ou de plusieurs propriétés physiques provenant du dispositif d'impression.
